## Europäisches Patentamt

## European Patent Office

## Office européen des brevets

(19)

(11) Veröffentlichungsnummer: **0 176 938**
**B1**

(12) **EUROPÄISCHE PATENTSCHRIFT**

(45) Veröffentlichungstag der Patentschrift:
**23.05.90**

(21) Anmeldenummer: **85112125.1**

(22) Anmeldetag: **25.09.85**

(51) Int. Cl.⁵: **H03K 19/173**

(54) Schaltung zur Logikgenerierung mit Multiplexern.

(30) Priorität: **28.09.84 DE 3435774**

(43) Veröffentlichungstag der Anmeldung: ·
**09.04.86 Patentblatt 86/15**

(45) Bekanntmachung des Hinweises auf die Patenterteilung:
**23.05.90 Patentblatt 90/21**

(84) Benannte Vertragsstaaten:
**AT DE FR GB IT NL**

(56) Entgegenhaltungen:
US-A- 3 576 984

ELECTRONICS, Band 42, Nr. 22, 27. Oktober 1969,
Seiten 100-105, New York, US; J.L. ANDERSON:
"Multiplexers double as logic circuits"
AUTOMATION AND REMOTE CONTROL, Nr. 8,
August 1968, Seiten 1310-1314, New York, US; V.G.
ZHUKOVSKII u.a.: "Logical block structure realizable
by means of microelectronics"
INTERNATIONAL JOURNAL OF ELECTRONICS,
Band 47, Nr. 3, September 1979, Seiten 253-266, London,
GB; Z.M. LOTFI et al.: "Using multiplexers to ralize
switching functions having particular properties"
THE RADIO AND ELECTRONICS ENGINEER, Band 50,

(73) Patentinhaber: **Siemens Aktiengesellschaft,
Wittelsbacherplatz 2, D-8000 München 2(DE)**

(72) Erfinder: **Hölzle, Josef, Dipl.-Ing.,
Neubeuernerstrasse 11, D-8000 München 21(DE)**

(56) Entgegenhaltungen: (Fortsetzung)
Nr. 7, Juli 1980, Seiten 363-366, Institution of Electronic
and Radio Engineers, London, GB; A.B. EKTARE u.a.:
"A simple algorithm for logic design using
multiplexers"

ACTORUM AG

**Beschreibung**

Die Erfindung betrifft eine Schaltung zur Generierung kombinatorischer Logik mit Multiplexern und Invertern, die bei jedem durch eine Kombination von Eingangsvariablen definierten Eingangszustand einen eindeutigen, durch mindestens eine Ausgangsvariable definierten Ausgangszustand besitzt.

Schaltungen zur Generierung kombinatorischer Logik gehören zu den Grundschaltungen der Digitaltechnik, die sich nach dem Stand der Technik mit zweistufigen OR-AND- oder AND-OR-Gatteranordnungen oder mit Hilfe von Multiplexern und Invertern realisieren lassen. Grundforderung für den Entwurf dieser Schaltungen ist es, bei vertretbarem Zeitaufwand mit einem Minimum an Schaltelementen auszukommen. In der Regel werden zur Lösung des jeweiligen Problems entweder Minterme, d.h. Konjunktionen, oder Maxterme, d.h. Disjunktionen aller Variabler herangezogen. Dabei benutzt man entweder diejenigen Minterme, die in der Sollfunktion einen logischen High-Pegel bewirken, oder diejenigen Maxterme, bei denen die Sollfunktion einen logischen Low-Pegel besitzt.

Möglichkeiten zur Minimierung des Schaltungsaufwandes bieten die Boolesche Algebra, die McCluskey-Methode oder die Karnaugh-Diagramme, die in dem Buch von K. Steinbuch und W. Rupprecht: "Nachrichtentechnik" 2. Auflage, 1973, Springer-Verlag, Berlin, Heidelberg, New York beschrieben sind. Beispielsweise aus James L. Anderson, "Multiplexers double as logic circuits, ELECTRONICS, Band 42, Nr. 22, 27. Oktober 1969, Seiten 100–105, bekannte Multiplexerschaltungen, die bei heutigen Technologien spezielle Hardwarerealisierungen besitzen, werden in der Regel mit Rechneralgorithmen minimiert, beispielsweise nach dem Aufsatz von A.B. Ektare und D.P. Mital "Simple Algorithm for Logic Design using Multiplexers" in "The Radio and Electronic Engineer", Vol. 50 (1980), No. 7, pp. 363 - 366.

Die bekannten Methoden zur Minimierung des Schaltungsaufwandes sind entweder umständlich, zeitaufwendig oder auf eine bestimmte Anzahl Eingangsvariabler beschränkt. Die Boolsche Algebra benutzt rein formale Methoden ohne System und die McCluscey-Methode ist zwar schematisch, aber umständlich; Karnaugh-Diagramme sind nur bis zu fünf Eingangsvariablen leicht handhabbar und die Ermittlung der günstigsten Steuervariablen bei Multiplexerschaltungen erfordert entweder Rechnerzeit oder viel Zeitaufwand bei einer Lösung von Hand.

Der Erfindung liegt die Aufgabe zugrunde, eine Multiplexerschaltung zur Generierung kombinatorischer Logik anzugeben, die bei einem Minimum an Zeitaufwand für ihren Entwurf mit einem Minimum an Schaltelementen auskommt.

Diese Aufgabe wird bei einer Schaltung der eingangs erwähnten Art erfindungsgemäß durch die Merkmale des kennzeichnenden Teils des Patentanspruchs 1 gelöst.

Ausgestaltungen des Erfindungsgedankens sind in Unteransprüchen gekennzeichnet.

Die Erfindung wird im folgenden anhand dreier Figuren näher erläutert, bei denen gleiche Elemente mit gleichen Bezugszeichen versehen sind.

Es zeigt:

Fig. 1 Ausführungsbeispiele für die aus Eingangsvariablen mit jeweils niedrigster Wertigkeit zu generierenden gleichgroßen Blöcke mit logischen Kombinationen,

Fig. 2 ein Ausführungsbeispiel einer erfindungsgemäßen Schaltung mit vier Eingangsvariablen und

Fig. 3 ein Ausführungsbeispiel einer erfindungsgemäßen Schaltung mit sechs Eingangsvariablen.

Der Erfindung liegt der Gedanke zugrunde, mit Hilfe von Multiplexern und Invertern aus den Eingangsvariablen mit jeweils niedrigster Wertigkeit logische Grundfunktionen, denen gleichgroße Blöcke mit logischen Kombinationen entsprechen, zu generieren. Aus einer Kombination dieser Blöcke ergeben sich die möglichen Ausgangszustände. Die Blöcke belegen die Dateneingänge einer Multiplexerschaltung und werden bei den Kombinationen der Eingangsvariablen, denen die logischen Kombinationen der Blöcke zugeordnet sind, zum Ausgang der Multiplexerschaltung durchgeschaltet. Dabei wird die Wahl des jeweils richtigen Blocks durch die Eingangsvariablen höherer Wertigkeit festgelegt, die die Adreßeingänge der Multiplexerschaltung belegen.

Neben dem geringen Zeitaufwand bei der Minimierung der benötigten Schaltelemente bedeutet die leichte Änderungsmöglichkeit der Sollfunktion, die die durch die Eingangszustände festgelegten Ausgangszustände angibt, einen weiteren Vorteil der erfindungsgemäßen Schaltung. Im Bedarfsfalle brauchen nur die an den Dateneingängen der Multiplexerschaltung anliegenden Blöcke ausgetauscht zu werden. Weitere Vorteile der erfindungsgemäßen Schaltung liegen darin, daß bis zu acht Eingangsvariable sehr leicht ohne Rechner beherrschbar sind und die Schaltzeit unabhängig von der Funktion der Ausgangsvariablen wird. Vorteilhafte Einsatzmöglichkeiten derartiger Multiplexerschaltungen bieten Gate-Arrays, speziell in ECL-Technik.

Für die Anwendung in dualer Binärlogik stehen standardmäßig Multiplexer zur Verfügung, die entweder einen Adreßeingang und zwei Dateneingänge oder zwei Adreßeingänge und vier Dateneingänge bei je einem Ausgang besitzen. Der logische Zustand der an den Adreßeingängen liegenden Steuervariablen bestimmt, welche der an den Dateneingängen liegenden Variablen zum Ausgang durchgeschaltet werden. Beispielsweise steuern die Adreßvariablen 00, 01, 10, 11 in dieser Reihenfolge die ihnen zugeordneten Dateneingänge 0, 1, 2, 3 an. Der Fan-out beträgt bis zu 10, bei höherer Ausgangsbelastung sind Puffer-Verstärker erforderlich. Aufgrund der für die Multiplexer verwendeten speziellen Hardwarerealisierung stehen die Ausgangsvariablen in der Regel auch invertiert zur Verfügung; ansonsten sind, ebenso wie für die Eingangsvariablen, Inverter erforderlich.

Erfindungsgemäß dienen nun die Eingangsvariablen mit jeweils niedrigster Wertigkeit zur Generierung 4-Bit-großer Blöcke mit den sich aus der Variation der Bits ergebenden 16 unterschiedlichen Kombinationen. Die Generierung größerer Blöcke, beispielsweise mit 8 Bits, ist zwar auch möglich, aber die sich dann ergebenden 256 Kombinationen sind unpraktisch zu handhaben. Die nachfolgend aufgelisteten Kombinationen der 4-Bit- Blöcke $A_0$ bis $A_{15}$ lassen sich mit Hilfe der beiden Eingangsvariablen niedrigster Wertigkeit $E_0$ und $E_1$ generieren.

**Tabelle 1:**

| $E_1E_0$ | $A_0$ | $A_1$ | $A_2$ | $A_3$ | $A_4$ | $A_5$ | $A_6$ | $A_7$ | $A_8$ | $A_9$ | $A_{10}$ | $A_{11}$ | $A_{12}$ | $A_{13}$ | $A_{14}$ | $A_{15}$ |
|---|---|---|---|---|---|---|---|---|---|---|---|---|---|---|---|---|
| 0 0 | 0 | 1 | 0 | 1 | 0 | 1 | 0 | 1 | 0 | 1 | 0 | 1 | 0 | 1 | 0 | 1 |
| 0 1 | 0 | 0 | 1 | 1 | 0 | 0 | 1 | 1 | 0 | 0 | 1 | 1 | 0 | 0 | 1 | 1 |
| 1 0 | 0 | 0 | 0 | 0 | 1 | 1 | 1 | 1 | 0 | 0 | 0 | 0 | 1 | 1 | 1 | 1 |
| 1 1 | 0 | 0 | 0 | 0 | 0 | 0 | 0 | 0 | 1 | 1 | 1 | 1 | 1 | 1 | 1 | 1 |

Der die Blöcke $A_i$ kennzeichnende Index i entspricht im Dezimalzahlencode der Bit-Kombination des zugeordneten Blockes im Dualzahlencode. Die Blöcke $A_{15}$ bis $A_8$ folgen in dieser Reihenfolge aus der Invertierung der Blöcke $A_0$ bis $A_7$. Der Block $A_0$ stellt den logischen Low-Pegel dar, und die Blöcke $A_3$ und $A_5$ sind die Invertierungen der Eingangsvariablen $E_1$ und $E_0$. Der logische Low- bzw. High-Pegel sowie die Eingangsvariablen $E_0$ und $E_1$ brauchen nicht gesondert generiert zu werden, da sie für eine erfindungsgemäße Schaltung notwendigerweise zur Verfügung stehen müssen. Setzt man voraus, daß jede Bitfolge auch in invertierter Form zur Verfügung steht oder durch Invertierung erzeugt wurde, so bleiben 5 Blöcke, die mit Hilfe von Multiplexern generiert werden müssen.

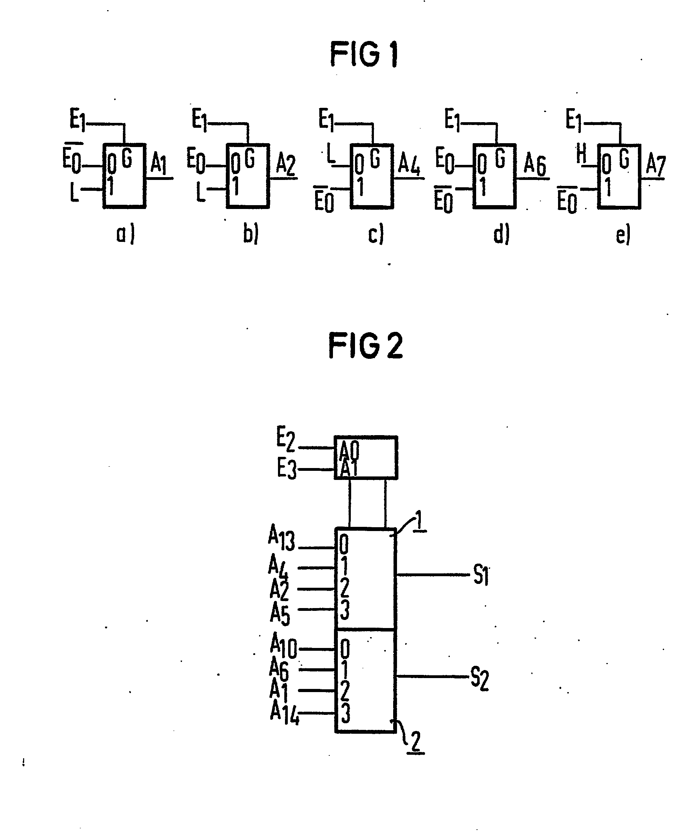

Fig. 1 stellt die zugehörigen Schaltungen in den Teilfiguren a bis e unter der Voraussetzung dar, daß die Eingangsvariable $E_1$ die Steuervariable sei. Für die Dateneingänge 0 und 1 bleiben dann der logische Low- bzw. High-Pegel und die Eingangsvariable $E_0$. Fig. 1a entspricht dem Block $A_1$: beim logischen Low-Pegel des Adreßeingangs G bzw. der Eingangsvariablen $E_1$ wird die invertierte Eingangsvariable $\bar{E}_0$, beim logischen High-Pegel des Adreßeingangs G wird der logische Low-Pegel zum Ausgang durchgeschaltet. Entsprechend generiert die Schaltung nach Fig.1b den Block $A_2$ Fig. 1c den Block $A_4$, Fig. 1d den Block $A_6$ und Fig. 1e den Block $A_7$.

Die Blöcke lassen sich ebenso gut generieren, wenn nicht die Eingangsvariable $E_1$, sondern die Eingangsvariable $E_0$ den Adreßeingang G belegt. Der Block $A_1$ läßt sich in diesem Fall durch die invertierte Eingangsvariable $\bar{E}_1$ am Dateneingang O, und Low-Pegel am Dateneingang 1 eines Multiplexers generieren. Die Realisierung aller 16 Ausgangskombinationen der Blöcke $A_0$ bis $A_{15}$ ist somit mit Hilfe von 5 Multiplexern mit jeweils zwei Dateneingängen und einem Ausgang sowie der Invertierung der Ausgänge möglich. Für die weitere Beschreibung sei vorausgesetzt, daß die Blöcke $A_0$ bis $A_{15}$ generiert sind und für Dateneingänge zur Verfügung stehen.

Im ersten Ausführungsbeispiel einer erfindungsgemäßen Schaltung sollen die durch die möglichen Kombinationen von vier Eingangsvariablen $E_0$ bis $E_3$ definierten Eingangszustände zu zwei, jeweils durch eine Ausgangsvariable dargestellten Ausgangszuständen führen. Die Ausgangszustände sind durch die Sollfunktionen $S_1$ und $S_2$ vorgegeben. Die Aufgabe läßt sich auch als Generierung jeweils eines Ausgangszustandes mit zwei Ausgangsvariablen interpretieren. Den Eingangsvariablen kommt die durch ihren Index gekennzeichnete Wertigkeit zu, beispielsweise besitzt die Eingangsvariable $E_0$ die Wertigkeit $2^0$, die Eingangsvariable $E_1$ die Wertigkeit $2^1$ usw.. Nachfolgend sind die den Kombinationen der Eingangsvariablen zugeordneten Ausgangszustände angegeben.

## Tabelle 2:

| $E_3$ | $E_2$ | $E_1$ | $E_0$ | $S_1$ | | $S_2$ | |
|---|---|---|---|---|---|---|---|
| 0 | 0 | 0 | 0 | 1 | | 0 | |
| 0 | 0 | 0 | 1 | 0 | $\hat{=} A_{13}$ | 1 | $\hat{=} A_{10}$ |
| 0 | 0 | 1 | 0 | 1 | | 0 | |
| 0 | 0 | 1 | 1 | 1 | | 1 | |
| 0 | 1 | 0 | 0 | 0 | | 0 | |
| 0 | 1 | 0 | 1 | 0 | $\hat{=} A_4$ | 1 | $\hat{=} A_6$ |
| 0 | 1 | 1 | 0 | 1 | | 1 | |
| 0 | 1 | 1 | 1 | 0 | | 0 | |
| 1 | 0 | 0 | 0 | 0 | | 1 | |
| 1 | 0 | 0 | 1 | 1 | | 0 | |
| 1 | 0 | 1 | 0 | 0 | $\hat{=} A_2$ | 0 | $\hat{=} A_1$ |
| 1 | 0 | 1 | 1 | 0 | | 0 | |
| 1 | 1 | 0 | 0 | 1 | | 0 | |
| 1 | 1 | 0 | 1 | 0 | | 1 | |
| 1 | 1 | 1 | 0 | 1 | $\hat{=} A_5$ | 1 | $\hat{=} A_{14}$ |
| 1 | 1 | 1 | 1 | 0 | | 1 | |

Erfindungsgemäß werden die aufeinanderfolgenden Ausgangszustände der Ausgangsvariablen in 4-Bit-Blöcke unterteilt. So entspricht der den dezimalen Eingangszuständen 0 bis 3 zugeordnete Ausgangszustand der Sollfunktion $S_1$ dem Block $A_{13}$ und der Ausgangszustand der Sollfunktion $S_2$ dem Block $A_{10}$. Entsprechend wird, wie in der Zuordnungstabelle geschehen, mit den den restlichen Eingangszuständen zugeordneten Ausgangszuständen verfahren.

Die Eingangsvariablen $E_0$ und $E_1$ wurden bereits zur Generierung der Blöcke $A_0$ bis $A_{15}$ herangezogen. Übrig bleiben die Eingangsvariablen $E_2$ und $E_3$, die die Adreßeingänge eines Multiplexers mit vier Dateneingängen belegen. An den Dateneingängen des Multiplexers liegen diejenigen in der obigen Zuordnungstabelle angegebenen Blöcke $A_i$, die bei entsprechender Steuerung durch die Eingangsvariablen $E_2$ und $E_3$ die Sollfunktionen $S_1$ und $S_2$ ergeben. Für die jeweils durch vier Blöcke definierten zwei Sollfunktionen sind zwei Multiplexer mit jeweils vier Dateneingängen und einem Ausgang erforderlich. Die zugehörige erfindungsgemäße Schaltung zeigt Fig. 2.

Bei jedem der vier möglichen Zustände der Adreßeingänge A0 und A1 muß ein vollständiger, an den ihnen zugeordneten Dateneingängen 0 bis 3 der Multiplexer 1 und 2 anliegender Block zum Ausgang durchgeschaltet werden. Obwohl kein spezieller Dekodierer erforderlich ist, geschieht eine Dekodierung der Eingangsvariablen $E_2$ und $E_3$ allein dadurch, daß sie die Adreßeingänge A0 und A1 mit den Wertigkeiten $2^0$ und $2^1$ ansteuern. Deshalb können beispielsweise beim Zustand 00 der Eingangsvariablen $E_2E_3$ die ihnen zugeordneten Dateneingänge 0 der Multiplexer 1 und 2 mit den Blöcken $A_{13}$ und $A_{10}$ zum Ausgang durchgeschaltet werden. Die in aufsteigender Reihenfolge der Adreßeingänge A0 und A1 bzw. der Eingangsvariablen $E_2$ und $E_3$ erfolgende Ansteuerung der Dateneingänge 0 bis 3 der Multiplexer 1 und 2 ergibt dann die Sollfunktion $S_1$ beim Multiplexer 1 und $S_2$ beim Multiplexer 2.

Verglichen mit möglichen Realisationen dieser Sollfunktionen $S_1$ und $S_2$ nach dem Stand der Technik unter Heranziehung von Mintermen oder Maxtermen erfordert die erfindungsgemäße Schaltung nach Fig. 2 weniger oder höchstens gleichviel Bauelemente bzw. Platz. Eine Änderung der Sollfunktion geschieht in einfacher Weise dadurch, daß die an den Dateneingängen der Multiplexer anliegenden Blöcke neu verschaltet werden.

Die Vorteile einer erfindungsgemäßen Schaltung kommen in der Regel erst bei mehr als vier Eigangsvariablen zum Tragen, wie für das zweite Ausführungsbeispiel mit 6 Eingangsvariablen demonstriert wird. Im zweiten Ausführungsbeispiel ist dabei ein spezieller Dekoder zur Ansteuerung der Multiplexer erforderlich. Die in diesem Fall zu generierende, durch eine Ausgangsvariable definierte Sollfunktion S wird in der nachfolgenden Zuordnungstabelle für die Ein- und Ausgangszustände wiederum in 4-Bit große Blöcke unterteilt.

## Tabelle 3:

| $E_5$ | $E_4$ | $E_3$ | $E_2$ | $E_1$ | $E_0$ | S | | $E_5$ | $E_4$ | $E_3$ | $E_2$ | $E_1$ | $E_0$ | S |
|---|---|---|---|---|---|---|---|---|---|---|---|---|---|---|
| 0 | 0 | 0 | 0 | 0 | 0 | 0 | | 1 | 0 | 0 | 0 | 0 | 0 | 0 |
| 0 | 0 | 0 | 0 | 0 | 1 | 1 | | 1 | 0 | 0 | 0 | 0 | 1 | 1 |
| 0 | 0 | 0 | 0 | 1 | 0 | 0 $\,\triangleq\, A_2$ | | 1 | 0 | 0 | 0 | 1 | 0 | 0 $\,\triangleq\, A_{10}$ |
| 0 | 0 | 0 | 0 | 1 | 1 | 0 | | 1 | 0 | 0 | 0 | 1 | 1 | 1 |
| 0 | 0 | 0 | 1 | 0 | 0 | 0 | | 1 | 0 | 0 | 1 | 0 | 0 | 1 |
| 0 | 0 | 0 | 1 | 0 | 1 | 1 | | 1 | 0 | 0 | 1 | 0 | 1 | 1 |
| 0 | 0 | 0 | 1 | 1 | 0 | 0 $\,\triangleq\, A_2$ | | 1 | 0 | 0 | 1 | 1 | 0 | 1 $\,\triangleq\, A_7$ |
| 0 | 0 | 0 | 1 | 1 | 1 | 0 | | 1 | 0 | 0 | 1 | 1 | 1 | 0 |
| 0 | 0 | 1 | 0 | 0 | 0 | 1 | | 1 | 0 | 1 | 0 | 0 | 0 | 1 |
| 0 | 0 | 1 | 0 | 0 | 1 | 1 | | 1 | 0 | 1 | 0 | 0 | 1 | 0 |
| 0 | 0 | 1 | 0 | 1 | 0 | 1 $\,\triangleq\, A_7$ | | 1 | 0 | 1 | 0 | 1 | 0 | 1 $\,\triangleq\, A_{13}$ |
| 0 | 0 | 1 | 0 | 1 | 1 | 0 | | 1 | 0 | 1 | 0 | 1 | 1 | 1 |
| 0 | 0 | 1 | 1 | 0 | 0 | 0 | | 1 | 0 | 1 | 1 | 0 | 0 | 0 |
| 0 | 0 | 1 | 1 | 0 | 1 | 0 | | 1 | 0 | 1 | 1 | 0 | 1 | 1 |
| 0 | 0 | 1 | 1 | 1 | 0 | 0 $\,\triangleq\, A_8$ | | 1 | 0 | 1 | 1 | 1 | 0 | 0 $\,\triangleq\, A_2$ |
| 0 | 0 | 1 | 1 | 1 | 1 | 1 | | 1 | 0 | 1 | 1 | 1 | 1 | 0 |
| 0 | 1 | 0 | 0 | 0 | 0 | 0 | | 1 | 1 | 0 | 0 | 0 | 0 | 0 |
| 0 | 1 | 0 | 0 | 0 | 1 | 1 | | 1 | 1 | 0 | 0 | 0 | 1 | 0 |
| 0 | 1 | 0 | 0 | 1 | 0 | 1 $\,\triangleq\, A_6$ | | 1 | 1 | 0 | 0 | 1 | 0 | 0 $\,\triangleq\, A_8$ |
| 0 | 1 | 0 | 0 | 1 | 1 | 0 | | 1 | 1 | 0 | 0 | 1 | 1 | 1 |
| 0 | 1 | 0 | 1 | 0 | 0 | 0 | | 1 | 1 | 0 | 1 | 0 | 0 | 1 |
| 0 | 1 | 0 | 1 | 0 | 1 | 1 | | 1 | 1 | 0 | 1 | 0 | 1 | 1 |
| 0 | 1 | 0 | 1 | 1 | 0 | 0 $\,\triangleq\, A_{10}$ | | 1 | 1 | 0 | 1 | 1 | 0 | 0 $\,\triangleq\, A_{11}$ |
| 0 | 1 | 0 | 1 | 1 | 1 | 1 | | 1 | 1 | 0 | 1 | 1 | 1 | 1 |
| 0 | 1 | 1 | 0 | 0 | 0 | 1 | | 1 | 1 | 1 | 0 | 0 | 0 | 0 |
| 0 | 1 | 1 | 0 | 0 | 1 | 1 | | 1 | 1 | 1 | 0 | 0 | 1 | 1 |
| 0 | 1 | 1 | 0 | 1 | 0 | 0 $\,\triangleq\, A_{11}$ | | 1 | 1 | 1 | 0 | 1 | 0 | 1 $\,\triangleq\, A_6$ |
| 0 | 1 | 1 | 0 | 1 | 1 | 1 | | 1 | 1 | 1 | 0 | 1 | 1 | 0 |
| 0 | 1 | 1 | 1 | 0 | 0 | 1 | | 1 | 1 | 1 | 1 | 0 | 0 | 0 |
| 0 | 1 | 1 | 1 | 0 | 1 | 0 | | 1 | 1 | 1 | 1 | 0 | 1 | 1 |
| 0 | 1 | 1 | 1 | 1 | 0 | 1 $\,\triangleq\, A_{13}$ | | 1 | 1 | 1 | 1 | 1 | 0 | 0 $\,\triangleq\, A_2$ |
| 0 | 1 | 1 | 1 | 1 | 1 | 1 | | 1 | 1 | 1 | 1 | 1 | 1 | 0 |

Den $2^6 = 64$ Eingangszuständen und damit 64 Ausgangszuständen entsprechen 16 Blöcke mit je 4 Bit. Im Beispielsfalle treten von den 16 möglichen Blöcken, die durch die Eingangsvariablen $E_0$ und $E_1$ definiert sind, sieben unterschiedliche Blöcke auf. Das Schaltverhalten dieser Blöcke bestimmen die Eingangsvariablen $E_2$ bis $E_5$. Da maximal zwei Eingangsvariable einen Multiplexer adressieren können, ist im Beispielsfall ein Dekoder erforderlich.

Zum Aufbau des Dekoders werden die unterscheidbaren Blöcke in aufsteigender Reihenfolge dual kodiert.

## Tabelle 4:

| Block | $B_2$ | $B_1$ | $B_0$ |
|-------|-------|-------|-------|
| $A_2$ | 0 | 0 | 0 |
| $A_7$ | 0 | 0 | 1 |
| $A_8$ | 0 | 1 | 0 |
| $A_6$ | 0 | 1 | 1 |
| $A_{10}$ | 1 | 0 | 0 |
| $A_{11}$ | 1 | 0 | 1 |
| $A_{13}$ | 1 | 1 | 0 |

Den sieben unterscheidbaren Blöcken $A_i$ sind die Codevariablen $B_0$ bis $B_2$ mit den Wertigkeiten $2^0$ bis $2^2$ zugeordnet. Jedes durch die Codevariablen $B_0$ bis $B_2$ definierte Codewort steht für vier, durch die Eingangsvariablen $E_0$ und $E_1$ definierte Ausgangszustände. Für die im Höchstfall auftretenden 16 unterscheidbaren Blöcke $A_i$ sind maximal 4 Codevariable $B_i$ erforderlich. Damit läßt sich der Dekoder analog zum im ersten Ausführungsbeispiel behandelten Fall mit 4 Eingangsvariablen behandeln und einstufig aufbauen.

Bei mehr als sechs Eingangsvariablen werden diejenigen mit Wertigkeiten größer $2^1$ in mehreren Stufen dekodiert. Die letzte Multiplexerstufe steuert mit Hilfe der kodierten Variablen die von $E_0$ und $E$ generierten Blöcke zum Ausgang durch.

Im vorliegenden Ausführungsbeispiel sind den Eingangsvariablen $E_2$ bis $E_5$ die durch die kodierten Ausgangsgleich Code-variablen $B_0$ bis $B_2$ definierten Ausgangszustände zuge-ordnet. Jede Codevariable $B_i$ läßt sich dabei als zu realisierende Sollfunktion auffassen. Entsprechend dem ersten Ausführungsbeispiel übernehmen die Eingangsvariablen $E_2$ und $E_3$ für den Dekoder die Aufgabe, Blöcke mit je 4-Bit zu generieren. Diese Blöcke liegen an den Dateneingängen der Multiplexer des Dekoders, die von den Eingangsvariablen $E_4$ und $E_5$ adressiert werden. Der Dekoder besitzt im Ausführungsbeispiel 3 Ausgänge, die jeweils einer Codevariablen $B_i$ zugeordnet sind und die die nachfolgenden Multiplexer ansteuern, an deren Dateneingängen die durch die Eingangsvariablen $E_0$ und $E_1$ generierten Blöcke liegen. Es ergibt sich folgende Zuordnung, die auch die eigentlich zu generierende Sollfunktion S in Form der durch die Eingangsvariablen $E_0$ und $E_1$ generierten Blöcke enthält.

## Tabelle 5:

| $E_5$ | $E_4$ | $E_3$ | $E_2$ | $B_2$ | $B_1$ | $B_0$ | $B_2$ | $B_1$ | $B_0$ | $S\ (E_1,E_0)$ |
|---|---|---|---|---|---|---|---|---|---|---|
| 0 | 0 | 0 | 0 | 0 | 0 | 0 | | | | $A_2$ |
| 0 | 0 | 0 | 1 | 0 | 0 | 0 | $A'_0$ | $A'_8$ | $A'_4$ | $A_2$ |
| 0 | 0 | 1 | 0 | 0 | 0 | 1 | | | | $A_7$ |
| 0 | 0 | 1 | 1 | 0 | 1 | 0 | | | | $A_8$ |
| 0 | 1 | 0 | 0 | 0 | 1 | 1 | | | | $A_6$ |
| 0 | 1 | 0 | 1 | 1 | 0 | 0 | $A'_{14}$ | $A'_9$ | $A'_5$ | $A_{10}$ |
| 0 | 1 | 1 | 0 | 1 | 0 | 1 | | | | $A_{11}$ |
| 0 | 1 | 1 | 1 | 1 | 1 | 0 | | | | $A_{13}$ |
| 1 | 0 | 0 | 0 | 1 | 0 | 0 | | | | $A_{10}$ |
| 1 | 0 | 0 | 1 | 0 | 0 | 1 | $A'_5$ | $A'_4$ | $A'_2$ | $A_7$ |
| 1 | 0 | 1 | 0 | 1 | 1 | 0 | | | | $A_{13}$ |
| 1 | 0 | 1 | 1 | 0 | 0 | 0 | | | | $A_2$ |
| 1 | 1 | 0 | 0 | 0 | 1 | 0 | | | | $A_8$ |
| 1 | 1 | 0 | 1 | 1 | 0 | 1 | $A'_2$ | $A'_5$ | $A'_6$ | $A_{11}$ |
| 1 | 1 | 1 | 0 | 0 | 1 | 1 | | | | $A_6$ |
| 1 | 1 | 1 | 1 | 0 | 0 | 0 | | | | $A_2$ |

Die Code- bzw. kodierte Ausgangsvariable $B_2$ des Dekoders läßt sich in diesem Fall durch die Blöcke $A'_0$, $A'_{14}$, $A'_5$ und $A'_2$ darstellen. Der hochgestellte Strich soll andeuten, daß diese Blöcke, obwohl sie die gleiche Bit-Folge wie die durch die Eingangsvariablen $E_0$ und $E_1$ generierten Blöcke besitzen, in diesem Fall durch die Eingangsvariablen $E_2$ und $E_3$ generiert werden. Die beiden Eingangsvariablen $E_4$ und $E_5$ können nun als Adreßeingänge für Multiplexer benutzt werden, da nur maximal 16 verschiedene Blöcke $A'_i$ auftreten. In diesem Fall werden 12 Blöcke benutzt.

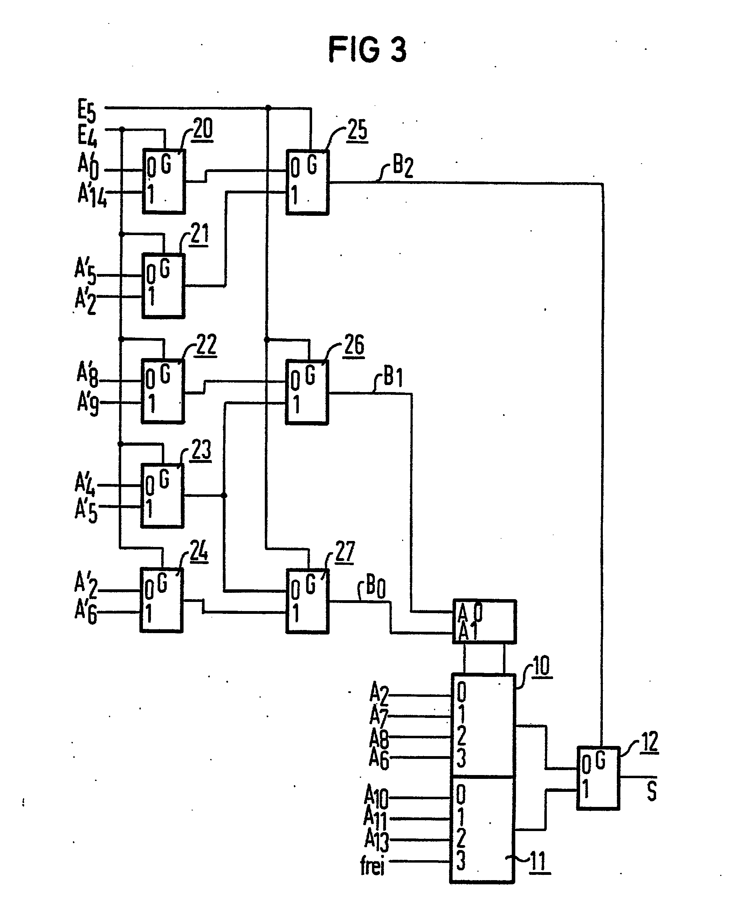

Der zum zweiten Ausführungsbeispiel gehörende Dekoder kann nun wie die erfindungsgemäße Schaltung des ersten Ausführungsbeispiels aufgebaut werden. In der erfindungsgemäßen Schaltung nach Fig. 3 wird jedoch ein anderer Weg gewählt, der sich direkt aus der Zuordnungstabelle für die Blöcke $A'_i$ ergibt. Dazu steuert die Eingangsvariable $E_4$ die Adreßeingänge von 5 Multiplexern 20 bis 24 mit je zwei Dateneingängen 0 und 1. Da die Blöcke $A'_4$ und $A'$ den Zuständen der Eingangsvariablen $E_4$ zweimal in dieser Reihenfolge gleich zugeordnet sind, genügen lediglich fünf von $E_4$ angesteuerte Multiplexer.

Die Blöcke $A'_i$ werden, beginnend bei der höchsten Wertigkeit der Codevariablen $B_i$ in aufsteigender Reihenfolge, bezogen auf die Eingangsvariablen $E_4$ und $E_5$, an die Dateneingänge 0 und 1 der Multiplexer 20 bis 24 gelegt. Da jedem logischen Zustand der Eingangsvariablen $E_5$ jeweils zwei Blöcke zugeordnet sind, stellen somit die Ausgänge der von $E_4$ gesteuerten Multiplexer gleichzeitig die Dateneingänge 0 und 1 der von $E_5$ gesteuerten nachfolgenden Multiplexer 25 bis 27 dar. Die Ausnahme bilden die von $E_4$ gesteuerten Blöcke $A'_4$ und $A'_5$, die zum einen dem Low-Pegel von $E_5$ zur Generierung der Code-variablen $B_0$ und zum anderen dem High-Pegel von $E_5$ zur Generierung der Codevariablen $B_1$ zugeordnet sind. Am Ausgang des Dekoders stehen dann die Codevariablen $B_0$, $B_1$ und $B_2$ zur Verfügung.

Für die sieben, den Eingangsvariablen $E_0$ bis $E_5$ zugeordneten unterscheidbaren Blöcke $A_i$ sind in der letzten Multiplexerstufe der Schaltung zwei Multiplexer 10 und 11 mit je vier Dateneingängen 0 bis 3 erforderlich. Die Adreßeingänge A0 und A1 für diese Multiplexer belegen die Codevariablen niedrigster Wertigkeit, nämlich $B_0$ und $B_1$. Die Auswahl zwischen den von diesen Codevariablen zum Ausgang der Multiplexer 10 und 11 durchgeschalteten Blöcke bildet ein Multiplexer 12 der letzten Multiplexerstufe mit

EP 0 176 938 B1

zwei Dateneingängen 0 und 1, der von der Codevariablen $B_2$ gesteuert wird. Am Ausgang dieses Multiplexers steht dann die gewünschte Sollfunktion S für die 6 Eingangsvariablen $E_0$ bis $E_5$ zur Verfügung.

Entsprechend sieht eine Schaltung mit mehr als acht, von den Eingangsvariablen $E_0$ und $E_1$ gesteuerten Blöcken aus, da dann vier Codevariable $B_i$ unterschiedlicher Wertigkeit als Adreßeingänge dienen.

Bei mehr als 6 Eingangsvariablen $E_i$ wird der Entwurf des Dekoders schrittweise so lange wiederholt, bis die Eingangsvariablen mit der Wertigkeit $2^{n-1}$ und $2^n$ als Adreßeingänge für Multiplexer übrigbleiben.

**Patentansprüche**

1. Schaltung zur Generierung kombinatorischer binärer Logik mit Multiplexern und Invertern, die bei jedem durch eine Kombination von Eingangsvariablen definierten Eingangszustand einen eindeutigen, durch mindestens eine Ausgangsvariable definierten Ausgangszustand besitzt und bei der die Eingangsvariablen ($E_i$) mit jeweils niedrigster Wertigkeit ($E_0$, $E_1$; $E_2$, $E_3$) zur Generierung logischer Grundfunktionen ($A_i$, $A'_i$) dienen, denen gleichgroße Blöcke mit logischen Kombinationen entsprechen und deren Auswahl durch die Eingangsvariablen höherer Wertigkeit ($E_2$, $E_3$; $E_4$, $E_5$) bestimmt wird, dadurch gekennzeichnet, daß mittels Zweifachmultiplexern aus den beiden niedrigstwertigen Variablen ($E_0$, $E_1$) diejenigen logischen Grundfunktionen ($A_i$) erzeugt werden, die sich durch Unterteilung der in einer die Abhängigkeit der Ausgangsvariablen von den Eingangsvariablen beschreibenden Wahrheitstabelle aufeinanderfolgenden Werte der Ausgangsvariablen in 4-Bit-Blöcke ergeben, und daß die erzeugten Grundfunktionen den Dateneingängen weiterer Multiplexer (1, 2, 10 bis 12) entsprechender Größe zugeführt und mittels der durch die restlichen Variablen ($E_2$, $E_3$; $E_4$, $E_5$) gebildeten Adreßinformationen als Ausgangssignal ausgewählt werden, wobei bei mehr als zwei restlichen Variablen aus den beiden niedrigstwertigen ($E_2$, $E_3$) wiederum mittels Zweifachmultiplexer weitere logische Grundfunktionen ($A'_i$) erzeugt und über eine Decodierschaltung (20 bis 27) als Adreßsignale ($B_0$ bis $B_2$) den weiteren Multiplexern zugeführt werden.

2. Schaltung nach Anspruch 1, dadurch gekennzeichnet, daß die Bit-Kombinationen der logischen Grundfunktionen ($A_i$, $A'_i$) durch die Eingangsvariablen der jeweils niedrigsten Wertigkeit ($E_0$, $E_1$; $E_2$, $E_3$) sowie einen logischen Low- oder High-Pegel definiert werden, indem eine am Adreßeingang (G) der Zweifach-Multiplexer liegende Eingangsvariable ($E_1$) die Auswahl der an den zugeordneten Dateneingängen (0, 1) anliegenden anderen Eingangsvariablen ($E_0$) und/oder des Low- oder High-Pegels steuert.

3. Schaltung nach Anspruch 2, dadurch gekennzeichnet, daß an den Dateneingängen (0, 1, 2, 3) der die letzte Stufe bildenden weiteren Multiplexer (10 bis 12) diejenigen von den Eingangsvariablen der Wertigkeiten $2^0$ und $2^1$ ($E_0$, $E_1$) generierten Grundfunktionen ($A_i$) anliegen, aus deren Kombination die Ausgangszustände (S) der Schaltung gebildet werden, und daß an den Adreßeingängen (A0, A1, G) dieser Stufe codierte Ausgangsvariable ($B_2$, $B_1$, $B_0$) der die vorletzte Stufe bildenden weiteren Multiplexer (20 bis 27) anliegen, die durch duale, in aufsteigender Reihenfolge erfolgte Codierung der von den Wertigkeiten $2^0$ und $2^1$ ($E_0$, $E_1$) gesteuerten Blöcke definiert sind und die die Multiplexer der letzten Stufe (10 bis 12) zur Anwahl der jeweils vier aufeinanderfolgende Ausgangszustände der Schaltung bestimmenden Grundfunktion ($A_i$) steuern, wobei die höchstens vier Wertigkeiten der Ausgangsvariablen ($B_i$) der Multiplexer (20 bis 27) der vorletzten Stufe jeweils zu Grundfunktionen ($A'_i$) von wiederum 4-Bit großen Blöcken zusammengefaßt sind, die an den Dateneingängen (0, 1) der Multiplexer (20 bis 27) der vorletzten Stufe anliegen und entsprechend den von den Eingangsvariablen mit den Wertigkeiten $2^0$ und $2^1$ ($E_0$, $E_1$) generierten Blöcke ($A_i$) nunmehr von den Eingangsvariablen der Wertigkeiten $2^2$ und $2^3$ ($E_2$, $E_3$) generiert werden und die zur Generierung codierter Ausgangsvariabler ($B_2$, $B_1$, $B_0$) mit maximal vier Wertigkeiten durchgeschaltet werden, indem die Adreßeingänge (G) der Multiplexer (20 bis 27) der vorletzten Stufe wiederum codierten Ausgangsvariablen der Multiplexer einer vorvorletzten Stufe gesteuert werden, die entsprechend der Codierung der Ausgangsvariablen ($B_2$, $B_1$, $B_0$) der vorletzten Stufe (20 bis 27) generiert werden, und stufenweise so fortschreitet, bis die Eingangsvariablen der Wertigkeiten $2^{n-1}$ und $2^n$ ($E_4$, $E_5$) für Adreßeingänge (G) von Multiplexern (20 bis 27) übrig bleiben.

**Claims**

1. Circuit for generating combinatorial binary logic functions using multiplexers and inverters, which has for each input state defined by a combination of input variables an unambiguous output state defined by at least one output variable and in which the input variables ($E_i$) having in each case the least significance ($E_0$, $E_1$; $E_2$, $E_3$) are used for generating basic logic functions ($A_i$, $A'_i$) which correspond to blocks with logical combinations and the selection of which is determined by the input variables with higher significance ($E_2$, $E_3$; $E_4$, $E_5$), characterized in that double multiplexers are used for generating from the two least significant variables ($E_0$, $E_1$) those basic logical functions ($A_i$) which result from the subdivision of the values, following one another in a truth table describing the dependence of the output variables on the input variables, of the output variables into 4-bit blocks, and that the basic functions generated are supplied to the data inputs of further multiplexers (1, 2, 10 to 12) of corresponding size and are selected as output signal by means of the address information items formed by the remaining variables ($E_2$, $E_3$;

9

EP 0 176 938 B1

E4, E5), during which process, if there are more than two remaining variables, further basic logical functions (A'i) are again generated from the two least significant values (E2, E3) by means of double multiplexers and are supplied via a decoding circuit (20 to 27) as address signals (B0 to B2) to the further multiplexers.

2. Circuit according to Claim 1, characterized in that the bit combinations of the basic logical functions (Ai; A'i) are defined by the input variables of the respective least significance (E0, E1; E2, E3) and a logical LOW or HIGH level by an input variable (E1) located at the address input (G) of the double multiplexers controlling the selection of the other input variables (E0) present at the associated data inputs (0, 1) and/or of the LOW or HIGH level.

3. Circuit according to Claim 2, characterized in that the basic functions (Ai) generated from the input variables having the significances $2^0$ and $2^1$ (E0, E1), from the combination of which the output states (S) of the circuit are formed, are present at the data inputs (0, 1, 2, 3) of the further multiplexers (10 to 12) forming the last stage, and that at the address inputs (A0, A1, G) of this stage coded output variables (B2, B1, B0) of the further multiplexers (20 to 27) forming the penultimate stage are present which are defined by dual coding, produced in ascending order, of the blocks controlled by the significances of $2^0$ and $2^1$ (E0, E1) and which control the multiplexers of the last stage (10 to 12) for selecting the basic function (Ai) in each case determining four successive output states of the circuit, the at the most four significances of the output variables (Bi) of the multiplexers (20 to 27) of the penultimate stage in each case being combined to form basic functions (Ai) of again 4-bit-large blocks which are present at the data inputs (0, 1) of the multiplexers (20 to 27) of the penultimate stage and, in accordance with the blocks (Ai) generated from the input variables of the significances $2^0$ and $2^1$ (E0, E1), are now generated from the input variables of the significances $2^2$ and $2^3$ (E2, E3) and which are switched through for generating coded output variables (B2, B1, B0) with a maximum of four significances by the address inputs (G) of the multiplexers (20 to 27) of the penultimate stage again being controlled by coded output variables of the multiplexers of a pre-penultimate stage which are generated in accordance with the coding of the output variables (B2, B1, B0) of the penultimate stage (20 to 27), and progressing step by step until the input variables of significances $2^{n-1}$ and $2^n$ (E4, E5) remain for address inputs (G) of multiplexers (20 to 27).

**Revendications**

1. Circuit pour produire une logique combinatoire binaire comportant des multiplexeurs et des inverseurs et qui, pour chaque état d'entrée défini par une combinaison de variables d'entrée, possède un état de sortie net, défini par au moins une variable de sortie, et dans lequel les variables d'entrée (Ei), qui possèdent respectivement le poids le plus faible (E0, E1; E2, E3), servent à produire des fonctions de base logiques (Ai, A'i), auxquelles correspondent des blocs possédant des combinaisons logiques et dont la sélection est déterminée par des variables d'entrée de poids supérieur (E2, E3; E4, E5), caractérisé par le fait que des multiplexeurs doubles produisent, à partir des deux variables de poids les plus faibles (E0, E1), les fonctions de base logiques (Ei), qui sont obtenues par subdivision, en des blocs de 4 bits, des valeurs de la variable de sortie, qui se succèdent dans une table de vérité décrivant la dépendance des variables de sortie par rapport aux variables d'entrée, que les fonctions de base produites sont envoyées aux entrées de données d'autres multiplexeurs (1, 2, 10 à 12) de taille correspondante et à l'aide desquels des informations d'adresses, formées par les variables restantes (E2, E3, E4, E5), sont sélectionnées en tant que signal de sortie, auquel cas à nouveau d'autres fonctions de base logique (A'i) sont produites, dans le cas de plus de deux variables restantes, à partir des deux variables de poids le plus faible (E2, E3), à l'aide de multiplexeurs doubles et sont envoyées en tant que signaux d'adresses (B0, B2) aux autres multiplexeurs par l'intermédiaire d'un circuit de décodage (20 à 27).

2. Circuit suivant la revendication 1, caractérisé par le fait que les combinaisons binaires des fonctions de base logique (Ai; A'i) sont définies par les variables d'entrée possédant respectivement le poids le plus faible (A0, A1; A2, A3) ainsi que par un niveau bas ou un niveau haut logique, par le fait qu'une variable d'entrée (E1) qui est présente à l'entrée d'adresse (G) du multiplexeur double commande la sélection des autres variables d'entrée (E0), appliquées aux entrées associées de données (0, 1) et/ou du niveau bas ou du niveau haut.

3. Circuit suivant la revendication 2, caractérisé par le fait qu'aux entrées de données (0, 1, 2, 3) des autres multiplexeurs (10 à 12) qui constituent le dernier étage sont appliquées des fonctions de base (Ai), qui sont produites par les variables d'entrée possédant les poids $2^0$ et $2^1$ (E0, E1) et à partir de la combinaison desquelles sont formés des états de sortie (S) du circuit, et qu'aux entrées d'adresses (A0, A1, G) de cet étage sont appliquées des variables de sortie codées (B2, B1, B0) des autres multiplexeurs (20 à 27) qui constituent l'avant-dernier étage et qui sont définis par un codage binaire, réalisé selon une séquence croissante, des blocs commandés par les poids $2^0$ et $2^1$ (E0, E1) et commandent la fonction de base (Ai), qui détermine les multiplexeurs du dernier étage (10 à 12) pour la sélection des quatre états successifs respectifs de sortie du circuit, auquel cas les poids, au maximum au nombre de quatre, des variables de sortie (Bi) des multiplexeurs (20 à 27) de l'avant-dernier étage sont réunis respectivement pour former des fonctions de base (A'i) de blocs d'une taille égale à nouveau à 4 bits, qui sont appliquées aux

EP 0 176 938 B1

entrées de données (0, 1) des multiplexeurs ($\underline{20}$ à $\underline{27}$) de l'avant-dernier étage et sont produites, en fonction des blocs ($A_i$) produits par les variables d'entrée possédant les poids $2^0$ et $2^1$ ($E_0$, $E_1$), par les variables d'entrée possédant les poids $2^2$ et $2^3$ ($E_2$, $E_3$) et sont transmises pour la production de variables de sortie codées ($B_2$, $B_1$, $B_0$) possédant au maximum quatre poids, par le fait que les entrées d'adresses ($G$) des multiplexeurs ($\underline{20}$ à $\underline{27}$) de l'avant-dernier étage sont à nouveau commandées par des variables de sortie, qui sont à nouveau codées, des multiplexeurs d'un étage situé en amont de l'avant-dernier étage, ces variables étant produites en·fonction du codage des variables de sortie ($B_2$, $B_1$, $B_0$) de l'avant-dernier étage ($\underline{20}$ à $\underline{27}$), le processus se poursuivant étage par étage jusqu'à ce que les variables d'entrée possédant les poids $2^{n-1}$ et $2^n$ ($E_4$, $E_5$) subsistent pour les entrées d'adresses ($G$) de multiplexeurs ($\underline{20}$ à $\underline{27}$).

11

# FIG 1

a)   b)   c)   d)   e)

# FIG 2

# FIG 3